(19) **Europäisches Patentamt**
**European Patent Office**
**Office européen des brevets**

(11) **EP 4 417 463 A1**

(12) # EUROPEAN PATENT APPLICATION
published in accordance with Art. 153(4) EPC

(43) Date of publication:
**21.08.2024 Bulletin 2024/34**

(21) Application number: **23887154.5**

(22) Date of filing: **19.09.2023**

(51) International Patent Classification (IPC):
**B60L 58/16** (2019.01)   **B60L 58/12** (2019.01)
**B60L 3/00** (2019.01)   **G01R 31/392** (2019.01)
**G01R 31/396** (2019.01)

(52) Cooperative Patent Classification (CPC):
**B60L 3/00; B60L 58/12; B60L 58/16; G01R 19/12;
G01R 31/36; G01R 31/367; G01R 31/378;
G01R 31/3842; G01R 31/385; G01R 31/389;
G01R 31/392; G01R 31/396; G06F 17/18;
H02J 7/00;** Y02E 60/10

(86) International application number:
**PCT/KR2023/014111**

(87) International publication number:
**WO 2024/136014 (27.06.2024 Gazette 2024/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **23.12.2022   KR 20220182657**

(71) Applicant: **POEN CO., LTD.
Uiwang-si, Gyeonggi-do 16014 (KR)**

(72) Inventors:
• **MUN, Duck Jin
  Seoul 04954 (KR)**
• **CHOI, Sung Jin
  Gwangmyeong-si, Gyeonggi-do 14241 (KR)**
• **LEE, Sang Uk
  Suwon-si, Gyeonggi-do 16685 (KR)**

(74) Representative: **Danubia Patent & Law Office LLC
Bajcsy-Zsilinszky út 16
1051 Budapest (HU)**

(54) **EVALUATION SYSTEM FOR REMANUFACTURING BATTERY SYSTEM OF ELECTRIC VEHICLE AND OPERATING METHOD THEREOF**

(57)   Disclosed is an evaluation system for remanufacturing of a battery system, the evaluation system including a charger/discharger connected to the battery system and used to charge and discharge the battery system; and an electronic device connected to the charger/discharger, receiving data about the battery system from the charger/discharger, and evaluating a remaining lifespan of the battery system based on the received data, wherein the electronic device selects at least one of a regular method and a simple method based on an input of a user, and evaluates a remaining lifespan of the battery system according to the at least one method selected above.

[FIG. 1]

EP 4 417 463 A1

**Description**

[Technical Field]

The present invention relates to an evaluation system for remanufacturing of an electric vehicle battery system and a method of operating the same.

[Background Art]

A secondary battery is a battery that can be repeatedly charged and discharged. The field where these secondary batteries are most widely used is the electric vehicle field. Electric vehicles are driven using electrical energy generated from a mounted secondary battery.

In addition, as the number of charging and discharging of the secondary battery increases, the energy storage capacity of the secondary battery gradually decreases. Accordingly, several electric vehicle manufacturers provide a service to replace secondary batteries with poor performance within a certain warranty period.

The replaced secondary battery is not immediately discarded, but can be reused as a battery for electric vehicles, considering the remaining lifespan or condition thereof, or used as a battery for other purposes through remanufacturing. However, because it is difficult to guarantee the performance of these reused or remanufactured batteries, a method of accurately evaluating the conditions of the reused or remanufactured batteries is required.

[Disclosure]

[Technical Problem]

Therefore, the present invention has been made in view of the above problems, and it is one object of the present invention to provide an evaluation system for remanufacturing of an electric vehicle battery system that is capable of evaluating state of health (SOH) representing the remaining lifespan of a battery system and a method of operating the evaluation system.

[Technical Solution]

In accordance with one aspect of the present invention, provided is an evaluation system for remanufacturing of a battery system including a charger/discharger connected to the battery system and used to charge and discharge the battery system; and an electronic device connected to the charger/discharger, receiving data about the battery system from the charger/discharger, and evaluating a remaining lifespan of the battery system based on the received data, wherein the electronic device selects at least one of a regular method and a simple method based on an input of a user, and the electronic device evaluates a remaining lifespan of the battery system according to the at least one method selected above.

It is another object of the present invention to provide a computer program recorded on a non-transitory recording medium for executing a method of operating the above-described evaluation system.

[Advantageous Effects]

According to embodiments of the present invention, state of health (SOH) representing the remaining lifespan of a battery system can be evaluated.

[Description of Drawings]

FIG. 1 shows a battery remanufacturing process according to embodiments of the present invention.
FIG. 2 shows an evaluation system according to embodiments of the present invention.
FIG. 3 is a diagram explaining the function of a test device according to embodiments of the present invention.
FIG. 4 shows a data analysis device according to embodiments of the present invention.
FIG. 5 is a flowchart for explaining a method of calculating the remaining lifespan of a battery system in a regular method according to embodiments of the present invention.
FIG. 6 is a flowchart for explaining a method of calculating the remaining lifespan of a battery system in a simple method according to embodiments of the present invention.

FIG. 7 is a diagram explaining a method of calculating the remaining lifespan of a battery system in a simple method according to embodiments of the present invention.

FIG. 8 is a diagram explaining a method of calculating the remaining lifespan of a battery system in a simple method according to embodiments of the present invention.

FIG. 9 is a flowchart for explaining a method of calculating the remaining lifespan of a battery system in a simple method according to embodiments of the present invention.

FIG. 10 is flowchart for explaining a method of calculating the remaining lifespan of a battery system in a simple method according to embodiments of the present invention.

FIGS. 11 to 13 show the operation screens of the evaluation system according to embodiments of the present invention.

[Best Mode]

Since the present invention may be applied with various modifications and may have various embodiments, exemplary embodiments and drawings of the present invention are intended to be explained and exemplified. However, these exemplary embodiments and drawings are not intended to limit the embodiments of the present invention to particular modes of practice, and all changes, equivalents, and substitutes that do not depart from the spirit and technical scope of the present invention should be understood as being encompassed in the present invention. Like reference numerals refer to like elements in describing each drawing.

The terms such as "first" and "second" are used herein merely to describe a variety of constituent elements, but the constituent elements are not limited by the terms. The terms are used only for the purpose of distinguishing one constituent element from another constituent element. For example, a first element may be termed a second element and a second element may be termed a first element without departing from the teachings of the present invention. As used herein, the term "and/or" includes any or all combinations of one or more of the associated listed items.

It should be understood that when an element is referred to as being "connected to" or "coupled to" another element, the element may be directly connected or coupled to the other element or intervening elements may be present. In contrast, when an element is referred to as being "directly connected to" or "directly coupled to" another element, there are no intervening elements present.

The terms used in the present specification are used to explain a specific exemplary embodiment and not to limit the present inventive concept. Thus, the expression of singularity in the present specification includes the expression of plurality unless clearly specified otherwise in context. Also, terms such as "include" or "comprise" should be construed as denoting that a certain characteristic, number, step, operation, constituent element, component or a combination thereof exists and not as excluding the existence of or a possibility of an addition of one or more other characteristics, numbers, steps, operations, constituent elements, components or combinations thereof.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, preferred embodiments according to the present invention will be described in detail with reference to the attached drawings.

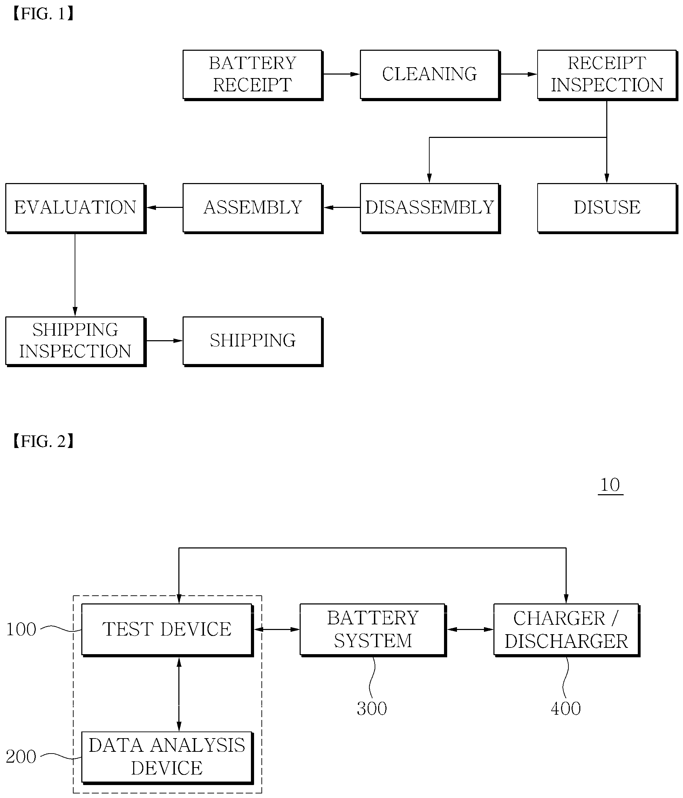

FIG. 1 shows a battery remanufacturing process according to embodiments of the present invention. Referring to FIG. 1, a replaced battery (e.g., waste battery) is received. Upon receipt, a receipt number is assigned to the received battery and an identification tag is attached thereto.

The received battery is subjected to a cleaning process. During the cleaning process, the battery case is cleaned and foreign substances and dust attached to the case are removed.

After cleaning, receipt inspection of the battery is performed. The receipt inspection includes visual inspection performed by examining the appearance of the battery with the naked eye, airtightness inspection to determine whether the airtightness of the battery is maintained, cooling passage inspection performed on a cooling passage for battery cooling, communication inspection performed on the communication capability of the battery, and inspection performed on the overall condition of the battery. Depending on the receipt inspection results, it is decided whether to remanufacture the battery or discard the battery. Batteries that do not meet prescribed standards may be discarded after receipt inspection.

The battery that passes the receipt inspection is subject to a disassembly process. During the disassembly process, the parts of the battery are disassembled, and parts to be reused and parts to be discarded are sorted out. Additional cleaning is performed on the parts to be reused.

The disassembled battery is reassembled. At this time, the disassembled battery may be assembled into a battery that fits a specific standard or specific purpose. Basic inspections may be performed on the assembled battery.

For example, airtightness inspection, cooling passage inspection, and communication inspection may be performed on the assembled battery.

Then, the battery condition is evaluated. According to embodiments, the remaining lifespan (SOH, state of health) of the battery is evaluated. When the remaining lifespan of the remanufactured battery is not long, the remanufactured battery may not be shipped as a final product and is not stored. Only a battery that satisfies a remaining lifespan above a certain level may be selected for shipping and is stored.

According to embodiments of the present invention, considering the characteristics of the battery and the properties of the test, at least one of various methods for evaluating the remaining lifespan of the battery may be selected. Based on the at least one method, the remaining lifespan of the battery may be evaluated. Accordingly, the remaining lifespan of the battery may be evaluated efficiently and accurately.

Once shipment of the stored battery is decided, the battery is shipped after a pre-shipment inspection is performed. At this time, the latest condition of the battery is checked before shipment through shipping inspection (e.g., the condition of the battery and the presence of any problems are checked through communication inspection, and appearance and airtightness inspection are performed). When the battery passes the shipping inspection, a shipping code (e.g., remanufacturing number) is assigned, shipping documents are created, the battery is packaged, and final transportation begins.

The present invention relates to an evaluation system for remanufacturing of an electric vehicle battery system that is capable of evaluating the remaining lifespan of the remanufactured battery more effectively and accurately and a method of operating the evaluation system.

FIG. 2 shows an evaluation system according to embodiments of the present invention. Referring to FIG. 2, an evaluation system 10 may include a test device 100, a data analysis device 200, a battery system 300, and a charger/discharger 400.

The test device 100 may perform tests on the battery system 300. The test device 100 may be electrically connected to the battery system 300 to obtain data related to the condition of the battery system 300. According to embodiments, the test device 100 may obtain data on the current condition of the battery system 300. For example, the test device 100 may be a cycler, but the present invention is not limited thereto.

The data analysis device 200 may receive and store data obtained from the test device 100.

The data analysis device 200 may analyze (or interpret) data about the stored battery system 300. According to embodiments, the data analysis device 200 may calculate the remaining lifespan of the battery system 300 using various data about the battery system 300 transmitted from the test device 100. The data analysis device 200 according to embodiments of the present invention may calculate the remaining lifespan of the battery system 300 in various methods (or modes). At this time, the calculation of the remaining lifespan of the battery system 300 may be performed for each cell included in the battery system 300, or may be performed for a module including at least two of the cells.

In addition, in FIG. 1, the test device 100 and the data analysis device 200 are shown as being configured separately. However, according to embodiments, the test device 100 and the data analysis device 200 may be configured as one test device.

The battery system 300 may store or discharge electrical energy. According to embodiments, the battery system 300 may include a secondary battery cell. The secondary battery cell may store electrical energy supplied from the outside or supply the stored electrical energy to the outside. According to embodiments, the battery system 300 may include a plurality of secondary battery cells. In addition, optionally, the battery system 300 may include a controller for controlling or managing a plurality of secondary battery cells. For example, the battery system 300 may be an energy storage device, but the present invention is not limited thereto.

The charger/discharger 400 may charge or discharge the battery system 300. According to embodiments, the charger/discharger 400 may supply alternating current or direct current power to the battery system 300 or receive alternating current or direct current power from the battery system 300. Through this process, the charger/discharger 400 may charge and discharge the battery system 300.

In addition, the charger/discharger 400 may operate under the control of the test device 100 or the data analysis device 200. According to embodiments, the charger/discharger 400 may receive charge/discharge schedule information of the battery system 300 from the test device 100 or the data analysis device 200. Based on the received charge/discharge schedule information, the charger/discharger 400 may charge/discharge the battery system 300.

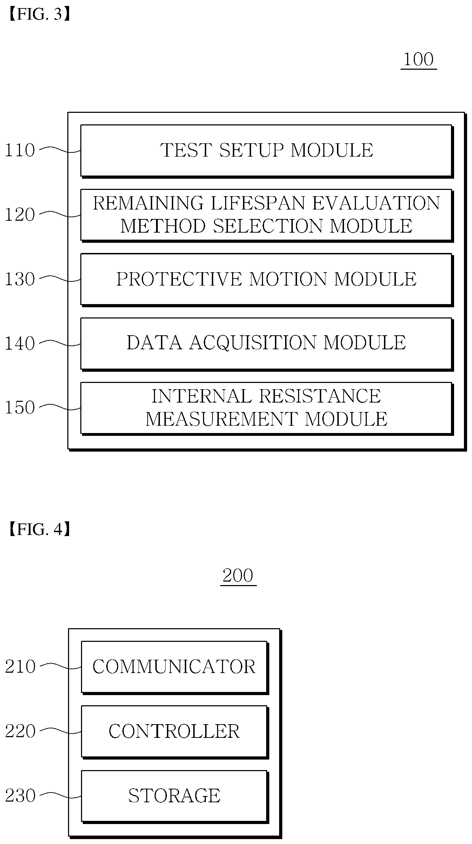

FIG. 3 is a diagram explaining the function of a test device according to embodiments of the present invention. Referring to FIG. 3, the test device 100 may include a plurality of modules 110, 120, 130, 140, and 150 (hereinafter referred to as 'modules 110 to 150'). The modules 110 to 150 are components for performing each function of the test device 100, and may be composed of at least one of hardware performing each function, software, and a combination thereof.

The test setup module 110 may set the properties of a test for the battery system 300. According to embodiments, the test setup module 110 may set information (e.g., vehicle model, model year, etc.) about a vehicle equipped with the battery system 300 that is being tested and information on the type (e.g., material (LFP, NMC, NCA, etc.)) and age of the battery system 300). At this time, the test setup module 110 may set the properties of the test for the battery system 300 based on input from the outside.

A remaining lifespan evaluation method selection module 120 may set a method for evaluating the remaining lifespan of the battery system 300 by the data analysis device 200.

According to embodiments of the present invention, the remaining lifespan of the battery system 300 may be evaluated according to a regular method or simple method.

The regular method is a method of evaluating the remaining lifespan from data on the battery system 300 obtained by fully charging and discharging the battery system 300, and the simple method is a method of evaluating the remaining lifespan from data on the battery system 300 obtained without a complete cycle of fully charging and discharging the battery system 300, for example, without fully discharging. At this time, the time required for the regular method may be longer than the time required for the simple method.

The electronic device may evaluate the remaining lifespan of the battery system 300 according to one simple method, or may evaluate the remaining lifespan of the battery system 300 according to two or more simple methods. The electronic device may evaluate the overall remaining lifespan of the battery system 300 by combining the evaluated remaining lifespan.

According to embodiments, the electronic device may evaluate the remaining lifespan of the first cells among a plurality of cells included in the battery system 300 using the regular method, may evaluate the remaining lifespan of the second cells using the first simple method, and may evaluate the remaining lifespan of the third cells using the second simple method. At this time, the electronic device may evaluate, as the remaining lifespan of the first cells, the remaining lifespan of the cells that have voltage-current characteristics and remaining lifespan similar to those of the first cells among the second and third cells. Accordingly, the electronic device may more accurately evaluate remaining lifespan.

A detailed description of the regular method and simple method will be provided later.

A protective motion module 130 may monitor the condition of the battery system 300 and stop charging/discharging or testing of the battery system 300 according to the monitoring results.

According to embodiments, the protective motion module 130 may monitor the voltage, temperature, and current of the battery system 300, and may determine whether the condition of the battery system 300 is abnormal according to the monitoring results. For example, the protective motion module 130 may determine overvoltage, undervoltage, high temperature, low temperature, and voltage deviation of the battery system 300. The protective motion module 130 may control the test device 100 to stop the test on the battery system 300 when an abnormality occurs, or may stop charging and discharging of the battery system 300 by controlling the charger/discharger 400.

According to embodiments, the protective motion module 130 may turn on or turn off a switch (or relay) connecting the battery system 300 and the external devices 100 and 400, thereby controlling the electrical connection between the battery system 300 and the external devices 100 and 400. Through this operation, the protective motion module 130 may stop charging/discharging or testing performed on the battery system 300.

A data acquisition module 140 may obtain data about the battery system 300. According to embodiments, the data acquisition module 140 may receive data related to cell voltage, cell current, cell temperature, or condition of the battery system 300 from the battery system 300 or the charger/discharger 400. For example, the data acquisition module 140 may receive data related to cell voltage, cell current, cell temperature, or condition of the battery system 300 from a controller (e.g., battery management system (BMS)) included in the battery system 300.

According to embodiments, the data acquisition module 140 may receive data about the battery system 300 from the battery system 300 or the charger/discharger 400 according to a wired communication method or a wireless communication method. For example, the data acquisition module 140 may receive data about the battery system 300 according to controller area network (CAN), CAN with flexible data rate (CANFD), local interconnect network (LIN), or an Ethernet method, but the embodiments of the present invention is not limited thereto.

Alternatively, the data acquisition module 140 may include measurement equipment that is electrically connected to the battery system 300 and measures the voltage, current, or temperature of the battery system 300, and may obtain data about the voltage, current, or temperature of the battery system 300 using the measurement equipment.

An internal resistance measurement module 150 may measure the internal resistance of the battery system 300. According to embodiments, the internal resistance measurement module 150 may measure alternating current internal resistance (AC IR) or direct current internal resistance (DC IR) of battery cells included in the battery system 300.

The alternating current internal resistance (AC IR) refers to the internal resistance measured under the conditions in which alternating current is applied to the battery system 300 (or battery cell), and the direct current internal resistance (DC IR) refers to the internal resistance measured under the condition in which direct current is applied to the battery system 300 (or battery cell).

According to embodiments, the internal resistance measurement module 150 may include AC internal resistance measurement equipment for measuring alternating current internal resistance (AC IR), and may measure the alternating current internal resistance (AC IR) of the battery system 300 using AC internal resistance measurement equipment.

In addition, according to embodiments, the internal resistance measurement module 150 may measure direct current internal resistance (DC IR) by controlling the charger/discharger 400. For example, the internal resistance measurement module 150 may be controlled to supply current for measuring alternating current internal resistance (DC IR) to the battery system 300 by controlling the charger/discharger 400.

FIG. 4 shows a data analysis device according to embodiments of the present invention. Referring to FIG. 4, the data analysis device 200 may include a communicator 210, a controller 220, and a storage 230.

The communicator 210 may exchange data with an external device. For example, the communicator 210 may exchange data with an external device according to a wired communication method or wireless communication method.

According to embodiments, the communicator 210 may exchange data with the test device 100, the battery system 300, or the charger/discharger 400. For example, the communicator 210 may receive condition information about the battery system 300 from the test device 100.

The controller 220 may control the overall operation of the data analysis device 200. For example, the controller 220 may include at least one processor, and the at least one processor may be central processing unit (CPU), micro controller unit (MCU), graphical processing unit (GPU), application specified integrated circuit (ASIC), or field programmable gate array (FPGA), but the embodiments of the present invention are not limited thereto.

The controller 220 may estimate or calculate the remaining lifespan of the battery system 300 using data related to the condition of the battery system 300 measured or obtained by the test device 100. Unless otherwise stated, the operation of the data analysis device 200 described in this specification may be understood as being performed under the control of the controller 220.

The storage 230 may store data necessary for the operation of the data analysis device 200. For example, the storage 230 may include non-volatile memory or volatile memory.

According to embodiments, the storage 230 may store a plurality of commands for controlling the operation of the data analysis device 200. The controller 220 may control the data analysis device 200 by loading the commands stored in the storage 230.

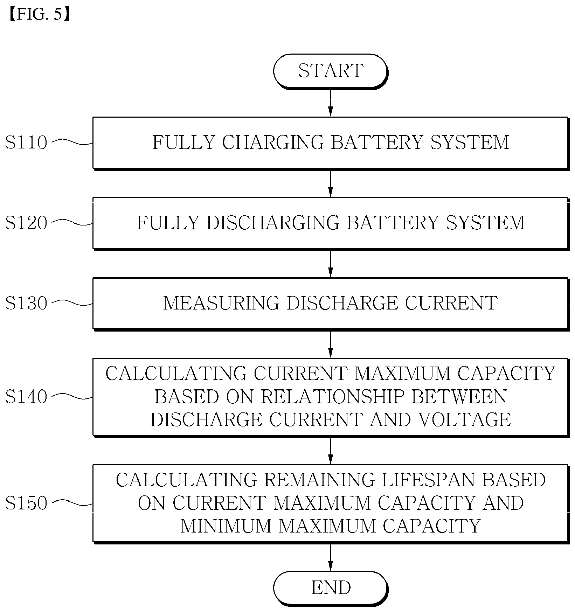

FIG. 5 is a flowchart for explaining a method of calculating the remaining lifespan of a battery system in a regular method according to embodiments of the present invention. The test device 100 or the data analysis device 200 may calculate the remaining lifespan of the battery system 300 using data about the battery system 300. Hereinafter, for convenience, the test device 100, the data analysis device 200, or a combination thereof will be referred to and described as an electronic device.

Referring to FIG. 5, the electronic device may fully charge the battery system 300 (S 110). According to embodiments, the electronic device may control the charger/discharger 400 to fully charge the battery system 300. Here, full charging means charging to a point where the charge level (state of charge (SOC)) of a battery is 100 %.

Then, the electronic device may fully discharge the battery system 300 (S120). According to embodiments, the electronic device may control the charger/discharger 400 to fully discharge the battery system 300. Here, full discharging means discharging to a point where the charge level (state of charge (SOC)) of a battery is 0 %.

Hereinafter, in this specification, when the electronic device charges or discharges the battery system 300, it is assumed that the electronic device controls the charger/discharger 400 connected to the battery system 300 to charge or discharge the battery system 300.

The electronic device measures the discharge current of the battery system 300 (S130). According to embodiments, the electronic device may obtain information about discharge current discharged from the battery system 300 while the battery system 300 goes from fully charged to fully discharged. At this time, the discharge current may be measured by the test device 100 or the charger/discharger 400.

The electronic device may calculate the current maximum capacity of the battery system 300 using the relationship between discharge current and voltage (S140). According to embodiments, the electronic device may calculate the current maximum capacity of the battery system 300 using information about the measured discharge current and voltage at the relevant point in time.

According to embodiments, the electronic device may calculate the current maximum capacity of the battery system 300 according to Equation 1 below.

[Equation 1]

$$CMax_{cur} = \int_{V_{min}}^{V_{max}} I_{dis}\, dt$$

Here, $CMax_{cur}$ is the current maximum capacity of the battery system 300, $V_{max}$ is the voltage when the battery system 300 is fully charged, $V_{min}$ is the voltage when the battery system 300 is fully discharged, and $I_{dis}$ is discharge current.

The electronic device may calculate the remaining lifespan of the battery system 300 using the current maximum capacity and initial maximum capacity of the battery system 300 (S150). According to embodiments, the electronic device may calculate the ratio of the current maximum capacity to the initial maximum capacity of the battery system 300 as remaining lifespan, that is, SOH. Here, information about the initial maximum capacity of the battery system 300 may be stored in advance.

That is, the electronic device may calculate the remaining lifespan of the battery system 300 according to Equation 2 below.

[Equation 2]

$$SOH = \frac{CMax_{cur}}{CMax_{bol}} \cdot 100$$

Here, SOH is the remaining lifespan of the battery system 300, $CMax_{cur}$ is the current maximum capacity of the battery system 300, $CMax_{bol}$ is the initial maximum capacity of the battery system 300, and 100 is a value to express remaining lifespan in %.

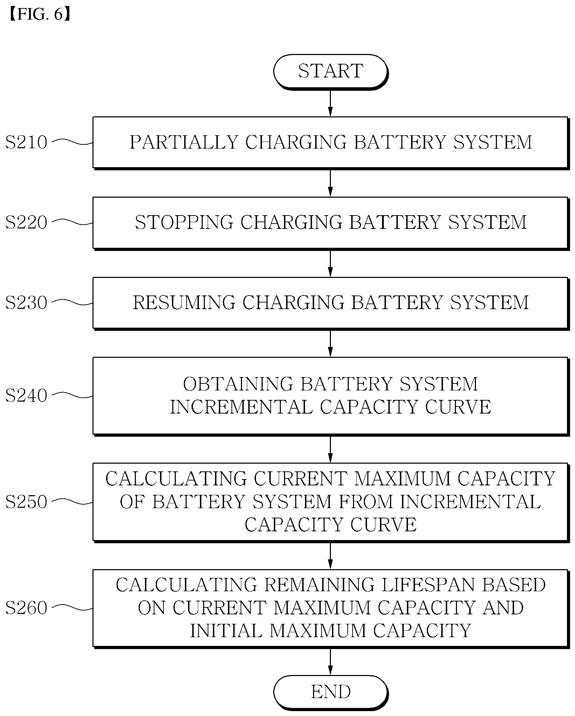

FIG. 6 is a flowchart for explaining a method of calculating the remaining lifespan of a battery system in a simple method according to embodiments of the present invention. Referring to FIG. 6, the electronic device may partially charge the battery system 300 (S210). Here, partial charging means charging to the point where the charge level (state of charge (SOC)) of a battery is less than 100%.

Then, the electronic device may stop charging the battery system 300 (S220). According to embodiments, the electronic device may stop charging the battery system 300 for a predetermined period of time.

After the pause, the electronic device may resume charging the battery system 300 (S230). According to embodiments, the electronic device may charge the battery system 300 to a predetermined charge amount.

The electronic device may obtain an incremental capacity curve for the battery system 300 (S240). According to embodiments, the electronic device may obtain data on the current and voltage of the battery system 300 for each time in the charging (or discharging) process of the battery system 300. Based on the obtained data, the electronic device may calculate the ratio (dV/dQ) of the change (dV) in voltage (V) to the change (dQ) in capacity (Q) obtained from current, and may obtain (or calculate) an incremental capacity curve by expressing this ratio (dQ/dV) to voltage (V).

The electronic device may calculate the current maximum capacity of the battery system 300 from the incremental capacity curve of the battery system 300 (S250). This process will be described later.

The electronic device may calculate the remaining lifespan of the battery system 300 using the current maximum capacity and initial maximum capacity of the battery system 300 (S260). According to embodiments, the electronic device may calculate the ratio of the current maximum capacity to the initial maximum capacity of the battery system 300 as remaining lifespan, that is, SOH. Here, information about the initial maximum capacity of the battery system 300 may be stored in advance.

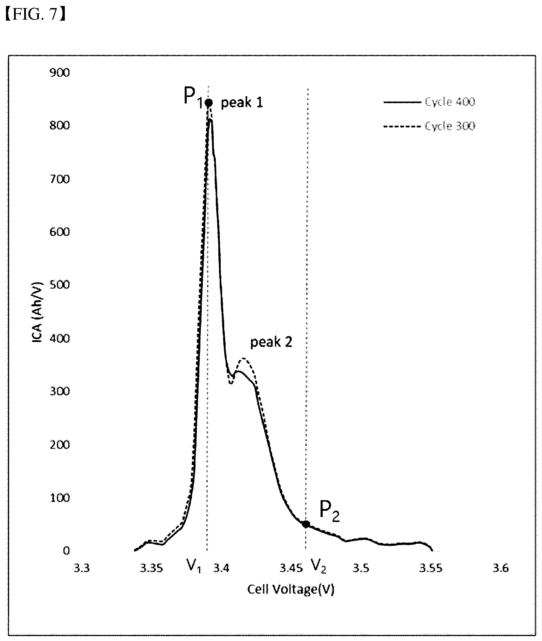

FIG. 7 is a diagram explaining a method of calculating the remaining lifespan of a battery system in a simple method according to embodiments of the present invention. Referring to FIG. 7, the incremental capacity curve for the battery system 300 is shown.

FIG. 7 shows the incremental capacity curve of a lithium-iron phosphate (LiFePO4 (LFP)) battery, and the incremental capacity curve may be obtained according to step S240 of the method described with reference to FIG. 6. That is, the method described with reference to FIG. 7 may be applied to the LFP battery. In addition, the incremental capacity curve represents incremental capacity during additional charging after partial charging of the battery system 300 (e.g., up to SOC 50 %).

Two points ($P_1$, $P_2$) appear on the incremental capacity curve. The point ($P_1$) represents a point (peak 1) where incremental capacity first reaches the maximum, and the point ($P_2$) represents a point where the battery system 300 reaches an open circuit voltage after the point ($P_1$). Voltages ($V_1$, $V_2$) are voltages corresponding to the points ($P_1$, $P_2$), respectively.

The electronic device may calculate the current maximum capacity of the battery system 300 by calculating the area below the incremental capacity curve between the points ($P_1$, $P_2$). For example, the electronic device may calculate the current maximum capacity of the battery system 300 according to Equation 3 below.

[Equation 3]

$$CMax_{cur} = \alpha_1 * \int_{V_1}^{V_2} IC(V) \, dV + \beta_1$$

Here, $CMax_{cur}$ is the current maximum capacity of the battery system 300, $V_1$ is a voltage corresponding to the first local maximum value in the incremental capacity curve, $V_2$ is an open circuit voltage, $IC(V)$ is an incremental capacity curve (or incremental capacity function), and $\alpha_1$ and $\beta_1$ are constants.

In addition, $\alpha_1$ and $\beta_1$ may be constants derived from the correlation between the area under the incremental capacity curve and current capacity for each of the various batteries, and may be constants previously stored for each of the battery system 300.

Then, the electronic device may calculate the remaining lifespan of the battery system 300 using the current maximum capacity and initial maximum capacity of the battery system 300.

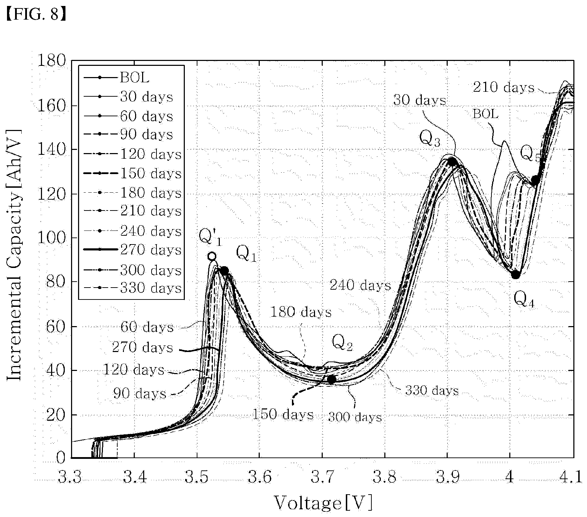

FIG. 8 is a diagram explaining a method of calculating the remaining lifespan of a battery system in a simple method according to embodiments of the present invention. Referring to FIG. 8, the incremental capacity curve for the battery system 300 is shown.

FIG. 8 shows the incremental capacity curve of a lithium-manganese oxide (LMO) battery or nickel-manganese-cobalt (NMC) battery, and the incremental capacity curve may be obtained according to step S240 of the method described with reference to FIG. 6. That is, the method to be described with reference to FIG. 8 may be applied to the LMO battery or NMC battery.

FIG. 8 shows incremental capacity curves according to the age of the battery system 300. As shown in FIG. 8, depending on the age of the battery system 300, the incremental capacity curve may vary even for the same battery system 300. For example, the incremental capacity curve of the battery system 300 in the initial condition is different from the incremental capacity curve of the battery system 300 after 30 days. The electronic device may calculate the remaining lifespan of the battery system 300 based on these facts.

The electronic device may calculate a current incremental capacity curve at the current of the battery system 300 and select an arbitrary point (e.g., Qi) on the incremental capacity curve. Then, the electronic device may determine an incremental capacity value at the selected arbitrary point ($Q_1$) and a point (e.g., $Q'_1$) on the incremental capacity curve at another point corresponding to the selected arbitrary point ($Q_1$), and may calculate current maximum capacity using the incremental capacity values at the two points ($Q_1$ and $Q'_1$). Here, the incremental capacity curve at another point in time may be a past incremental capacity curve at a time in the past before the current, for example, an initial incremental capacity curve at an initial point in time, but the present invention is not limited thereto. However, for convenience of explanation, the initial incremental capacity curve is explained below.

Information about the initial incremental capacity curve may be stored in advance. A point (e.g., Qi) on the current incremental capacity curve and a point ($Q'i$) on the initial capacity curve corresponding to the point (Qi) may have the same value or the same trend. Here, the same trend means that the values of N derivatives (N is a natural number greater than 1) are the same. For example, the electronic device may select the first pole point (i.e., the first point where the first derivative of the incremental capacity curve is 0 and the second derivative of the incremental capacity curve is not 0) on the current incremental capacity curve as the point (Qi). In addition, the first pole point on the initial incremental capacity curve may be selected as the corresponding point ($Q'_1$).

For example, the electronic device may calculate current maximum capacity according to Equation 4 below.

[Equation 4]

$$CMax_{cur} = CMax_{bol} * \left(1 - \frac{\alpha_2 * \left(\frac{IC_{cur}}{IC_{bol}} * 100\right)^{\beta_2}}{100}\right)$$

Here, $CMax_{cur}$ is the current maximum capacity of the battery system 300, $CMax_{bol}$ is the initial maximum capacity of the battery system 300, $IC_{cur}$ is an incremental capacity value at a point (e.g., Qi) on a current incremental capacity curve, $IC_{bol}$ is an incremental capacity value at a corresponding point (e.g., $Q'_1$) on an initial incremental capacity curve, and $\alpha_2$ and $\beta_2$ are constants.

In addition, $\alpha_2$ and $\beta_2$ may be constants derived from the correlation between incremental capacity values at various lifespans for each of various batteries, and may be constants pre-stored for the battery system 300.

Alternatively, the electronic device may calculate current maximum capacity using a voltage value instead of the incremental capacity value of the point of the incremental capacity curve of the battery system 300. For example, the electronic device may calculate current maximum capacity using a voltage value at an arbitrary point (e.g., $Q_1$) on a current incremental capacity curve and a voltage value at a point (e.g., $Q'_1$) on an incremental capacity curve at a different time corresponding to the selected arbitrary point ($Q_1$).

For example, the electronic device may calculate current maximum capacity according to Equation 5 below.

[Equation 5]

$$CMax_{cur} = CMax_{bol} * \left(1 - \frac{\alpha_3 * \left(\frac{V_{cur}}{V_{bol}} * 100\right)^{\beta_3}}{100}\right)$$

Here, $CMax_{cur}$ is the current maximum capacity of the battery system 300, $CMax_{bol}$ is the initial maximum capacity of the battery system 300, $V_{cur}$ is a voltage value at the point (e.g., $Q_1$) on a current incremental capacity curve, $V_{bol}$ a voltage value at the corresponding point (e.g., $Q'_1$) on an initial incremental capacity curve, and $\alpha_3$ and $\beta_3$ are constants.

In addition, $\alpha_3$ and $\beta_3$ may be constants derived from the correlation between voltage values at various lifespans for each of various batteries, and may be constants pre-stored for the battery system 300.

According to embodiments, as described above, the electronic device may calculate the current maximum capacity of the battery system 300 using the value (e.g., incremental capacity value or voltage value) of a pair of points consisting of a point on the current incremental capacity curve and a point on the corresponding initial incremental capacity curve. In addition, the electronic device may calculate the current maximum capacity of the battery system 300 using a plurality of pairs of points (e.g., $Q_2$ to $Q_5$ and corresponding points on the initial incremental capacity curve), each consisting of a point on the current incremental capacity curve and a point on the corresponding initial incremental capacity curve. At this time, the electronic device may calculate the current maximum capacity using statistics of current maximum capacity values calculated by each of a plurality of pairs of points.

For example, the electronic device may calculate current maximum capacity according to Equation 6 below.

[Equation 6]

$$CMax_{cur,total} = e^{\sum_{i=1}^{K} \ln (CMax_{cur,i})/K}$$

Here, $CMax_{cur,total}$ is the overall current maximum capacity of the battery system 300 calculated using a plurality of pairs of points, and $CMax_{cur,i}$ is the current maximum capacity of the battery system 300 calculated from the ith pair of points among the total K (K is a natural number).

In addition, the electronic device may calculate current maximum capacity according to Equation 7 below.

[Equation 7]

$$CMax_{cur,total} = e^{\sum_{i=1}^{K} w_i * \ln (CMax_{cur,i})/K}$$

Here, $w_i$ is a weight applied to the current maximum capacity of the battery system 300 calculated from the ith pair of points.

At this time, the weight $w_i$ may be determined based on the difference in voltage values between two points included in the ith pair of points. For example, the electronic device may calculate weight $w_i$ according to Equation 8 below.

[Equation 8]

$$w_i = \frac{dist_i - \frac{\sum_{j=1}^K dist_j}{K}}{\sqrt{\frac{\sum_{j=1}^K dist_j{}^2}{K} - (\frac{\sum_{j=1}^K dist_j}{K})^2}}$$

Here, dist; is the difference in voltage values between two points included in the ith pair of points.

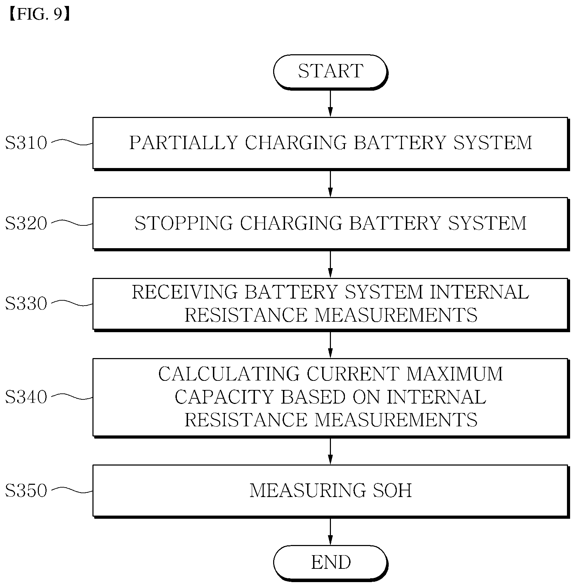

FIG. 9 is a diagram explaining a method of calculating the remaining lifespan of a battery system in a simple method according to embodiments of the present invention. Referring to FIG. 9, the electronic device may partially charge the battery system 300 (S310). According to embodiments, the electronic device may control the charger/discharger 400 to partially charge the battery system 300.

Then, the electronic device may stop charging the battery system 300 (S320). According to embodiments, the electronic device may stop charging the battery system 300 for a predetermined period of time.

The electronic device may receive measurement values for the internal resistance of the battery system 300 (S330). According to embodiments, measurement values for the internal resistance of the battery system 300 may be measured by a separate internal resistance measurement device and then transmitted from the internal resistance measurement device to the electronic device. The internal resistance measurement values may be measurement values for alternating current internal resistance (AC-IR) or direct current internal resistance (DC-IR).

The electronic device may calculate the current maximum capacity of the battery system 300 using the internal resistance measurement values (S340). According to embodiments, the electronic device may calculate the current maximum capacity of the battery system 300 according to regression analysis using the internal resistance measurement values as variables.

For example, the electronic device may calculate the current maximum capacity of the battery system 300 according to Equation 9 below.

[Equation 9]

$$CMax_{cur} = \alpha_4 * IR + \beta_4$$

Here, $CMax_{cur}$ is the current maximum capacity of the battery system 300, IR is the internal resistance measurement value of the battery system 300, and $\alpha_4$ and $\beta_4$ are constants.

In addition, $\alpha_4$ and $\beta_4$ may be constants derived from the correlation between an internal resistance measurement value and capacity for each of various batteries, and may be constants pre-stored for the battery system 300.

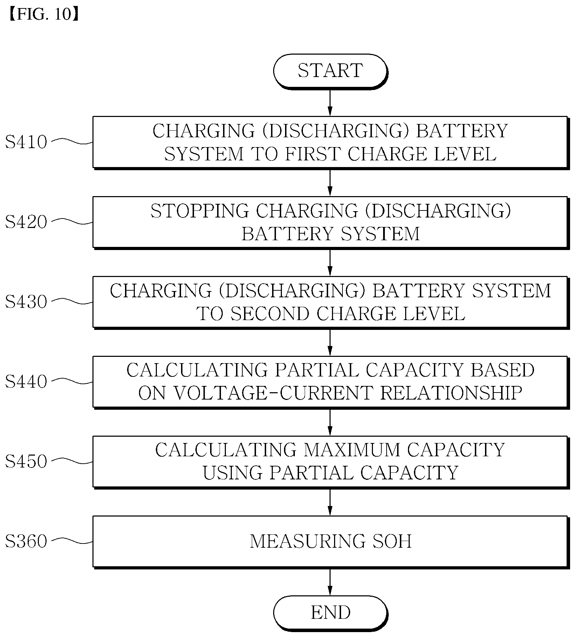

FIG. 10 is a diagram explaining a method of calculating the remaining lifespan of a battery system using the simple method according to embodiments of the present invention. Referring to FIG. 10, the electronic device may charge (or discharge) the battery system 300 to the first charge level (S410). That is, the electronic device may charge or discharge the battery system 300 so that the charge amount of the battery system 300 reaches the first charge level.

Then, the electronic device may pause charging or discharging the battery system 300 (S420). According to embodiments, the electronic device may stop charging (or discharging) the battery system 300 for a predetermined period of time.

The electronic device may charge (or discharge) the battery system 300 to the second charge level (S430). When the second charge level is less than the first charge level, the electronic device discharges the battery system 300. When the second charge level is greater than the first charge level, the electronic device charges the battery system 300.

The electronic device may calculate the current partial capacity of the battery system 300 using the relationship between the charge/discharge current and voltage of the battery system 300 (S440). According to embodiments, the electronic device may calculate the current partial capacity of the battery system 300 using information about the measured charge/discharge current and voltage at the relevant point in time.

According to embodiments, the electronic device may calculate the current partial capacity of the battery system 300 according to Equation 10 below.

[Equation 10]

$$CPar_{cur} = \int_{V_1}^{V_2} I \, dt$$

Here, $CPar_{cur}$ is the current partial capacity of the battery system 300, $V_1$ is a voltage corresponding to the first charge level of the battery system 300, $V_2$ is a voltage corresponding to the second charge level of the battery system 300, and I is the charge/discharge current of the battery system 300.

The electronic device may calculate the current maximum capacity of the battery system 300 from the calculated partial capacity of the battery system 300. For example, the electronic device may calculate the current maximum capacity of the battery system 300 according to Equation 11 below.

[Equation 11]

$$CMax_{cur} = \alpha_5 * CPar_{cur} + \beta_5$$

Here, $CMax_{cur}$ is the current maximum capacity of the battery system 300, $CPar_{cur}$ is the current partial capacity of the battery system 300, and $\alpha_5$ and $\beta_5$ are constants.

In addition, $\alpha_5$ and $\beta_5$ may be constants derived from the correlation between partial capacity and charge amount for each of various batteries, and may be constants pre-stored for the battery system 300. At this time, $\alpha_5$ and $\beta_5$ may vary when the charge amount is different even when the battery system 300 is of the same type.

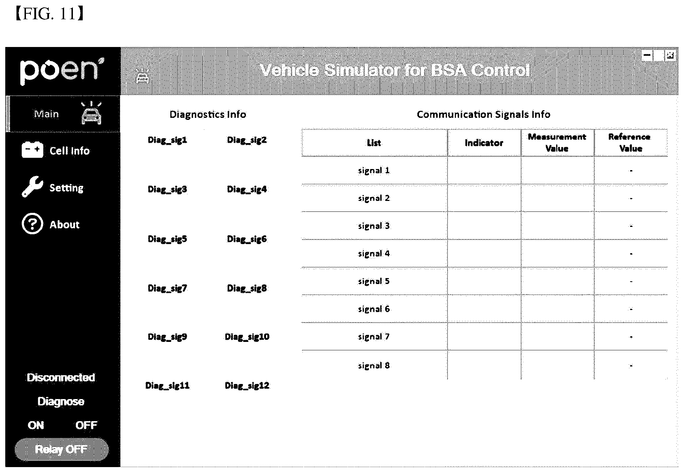

FIGS. 11 to 13 show the operation screens of the evaluation system according to embodiments of the present invention. The screen shown in FIGS. 11 to 13 may be displayed through a display connected to a test device or data analysis device.

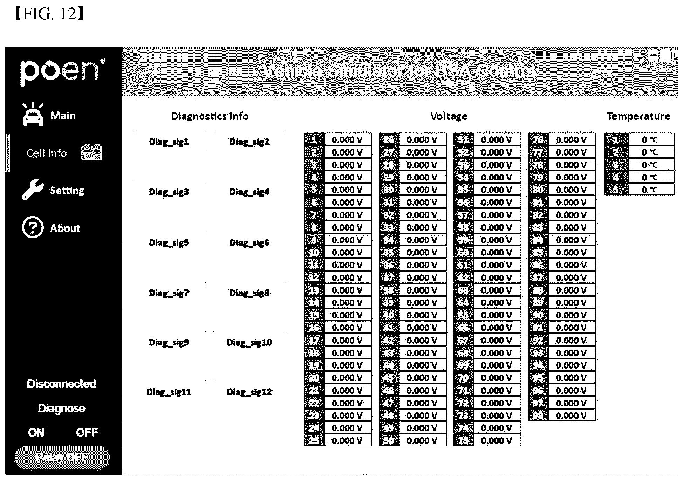

Referring to FIGS. 11 and 12, the evaluation system may receive measurement data for each of a plurality of connected battery systems 300 and information on the conditions thereof, and may display the measurement data and the information. For example, the evaluation system may display voltage, temperature, and condition information for each of the battery systems 300.

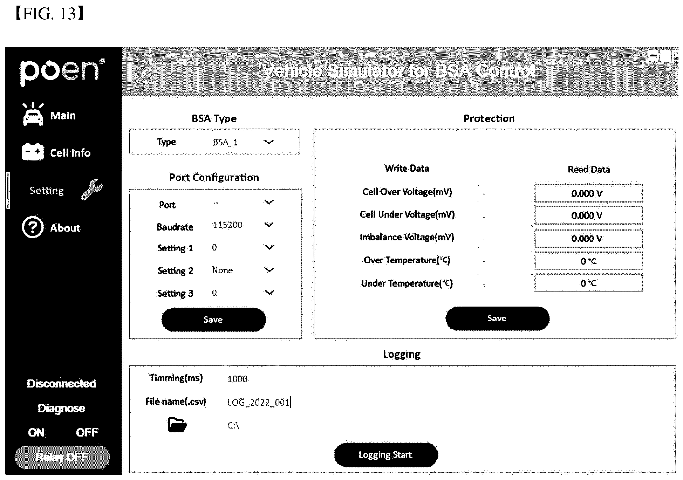

Referring to FIG. 13, the evaluation system may display a screen where a user may select various settings for the battery system. For example, the evaluation system may display a screen where a user may set the type of a battery system, the protection function for the battery system, and the data storage path of the battery system.

The methods according to the embodiments of the present invention may be implemented in the form of a program command that can be executed through various computer means and recorded in a computer-readable medium. The computer-readable medium can store program commands, data files, data structures or combinations thereof. The program commands recorded in the medium may be specially designed and configured for the present invention or be known to those skilled in the field of computer software.

Examples of a computer-readable recording medium include magnetic media such as hard disks, floppy disks and magnetic tapes, optical media such as CD-ROMs and DVDs, magnetooptical media such as floptical disks, or hardware devices such as ROMs, RAMs and flash memories, which are specially configured to store and execute program commands. Examples of the program commands include machine language code created by a compiler and high-level language code executable by a computer using an interpreter and the like. The hardware devices described above may be configured to operate as one or more software modules to perform the operations of the embodiments, and vice versa.

In addition, the above-described method or device may be implemented by combining all or part of components or functions thereof, or may be implemented separately.

Although the present invention has been described above with reference to the embodiments of the present invention, those skilled in the art may variously modify and change the present invention without departing from the spirit and scope of the present invention as set forth in the claims below.

**Claims**

1. An evaluation system for remanufacturing of a battery system, comprising:

a charger/discharger connected to the battery system and used to charge and discharge the battery system; and an electronic device connected to the charger/discharger, receiving data about the battery system from the charger/discharger, and evaluating a remaining lifespan of the battery system based on the received data, wherein the electronic device selects at least one of a regular method and a simple method based on an input of a user, and

the electronic device evaluates a remaining lifespan of the battery system according to the at least one method selected above.

2. The evaluation system according to claim 1, wherein the regular method is a method of evaluating a remaining lifespan from data obtained during a complete cycle of fully charging and discharging the battery system, and the simple method is a method of evaluating a remaining lifespan from data obtained without the complete cycle for the battery system.

3. The evaluation system according to claim 2, wherein, when the regular method is selected, the electronic device fully charges the battery system and fully discharges the battery system,

the electronic device receives data on discharge current and voltage of the battery system during full charging or full discharging of the battery system,
the electronic device calculates a current maximum capacity of the battery system based on relationship between discharge current and voltage of the battery system, and
the electronic device calculates a remaining lifespan of the battery system based on the current maximum capacity and an initial maximum capacity of the battery system.

4. The evaluation system according to claim 2, wherein, when the simple method is selected, the electronic device partially charges the battery system,

the electronic device stops charging the battery system for a predetermined period of time,
the electronic device resumes charging the battery system,
the electronic device receives data about current and voltage of the battery system during charging of the battery system,
the electronic device obtains a current incremental capacity curve in a current condition of the battery system based on the data,
the electronic device calculates a current maximum capacity of the battery system based on the current incremental capacity curve, and
the electronic device calculates a remaining lifespan of the battery system based on the current maximum capacity and an initial maximum capacity of the battery system.

5. The evaluation system according to claim 4, wherein the electronic device determines a first point on the current incremental capacity curve at which an incremental capacity of the battery system is first local maximized,

the electronic device determines a second point on the current incremental capacity curve at which the battery system reaches an open circuit voltage after the first point, and
the electronic device calculates an area under the current incremental capacity curve from the first point to the second point, and calculates a current maximum capacity of the battery system based on the calculated area.

【FIG. 1】

```
┌──────────────┐     ┌──────────────┐     ┌──────────────┐
│   BATTERY    │ ──> │   CLEANING   │ ──> │   RECEIPT    │
│   RECEIPT    │     │              │     │  INSPECTION  │
└──────────────┘     └──────────────┘     └──────────────┘
                                                  │
                                  ┌───────────────┴───────────────┐
                                  ▼                               ▼
┌──────────────┐  ┌──────────────┐  ┌──────────────┐     ┌──────────────┐
│  EVALUATION  │<─│   ASSEMBLY   │<─│ DISASSEMBLY  │     │    DISUSE    │
└──────────────┘  └──────────────┘  └──────────────┘     └──────────────┘
       │
       ▼
┌──────────────┐     ┌──────────────┐
│   SHIPPING   │ ──> │   SHIPPING   │
│  INSPECTION  │     │              │
└──────────────┘     └──────────────┘
```

【FIG. 2】

10

```
        ┌─────────────────────────────────────────────────────────┐
        │                                                         │
        ▼                                                         ▼
┌ ─ ─ ─ ─ ─ ─ ─ ─ ─ ─ ─ ─ ─ ┐
     ┌──────────────┐            ┌──────────────┐     ┌──────────────┐
100 │ │ TEST DEVICE  │ ────────>  │   BATTERY    │<───>│  CHARGER /   │
     └──────────────┘        │   │    SYSTEM    │     │  DISCHARGER  │
│           ▲                     └──────────────┘     └──────────────┘
            │               │            │                    │
│           ▼                          300                   400
     ┌──────────────┐        │
200 │ │ DATA ANALYSIS│
     │    DEVICE     │       │
     └──────────────┘
└ ─ ─ ─ ─ ─ ─ ─ ─ ─ ─ ─ ─ ─ ┘
```

【FIG. 3】

100

| TEST SETUP MODULE | 110 |
| REMAINING LIFESPAN EVALUATION METHOD SELECTION MODULE | 120 |
| PROTECTIVE MOTION MODULE | 130 |
| DATA ACQUISITION MODULE | 140 |
| INTERNAL RESISTANCE MEASUREMENT MODULE | 150 |

【FIG. 4】

200

| COMMUNICATOR | 210 |
| CONTROLLER | 220 |
| STORAGE | 230 |

【FIG. 5】

```
                        ╭─────────────╮
                        │    START    │
                        ╰──────┬──────╯
                               │
                               ▼
         ┌──────────────────────────────────────────────┐
S110 ~─ │        FULLY CHARGING BATTERY SYSTEM           │
         └───────────────────────┬──────────────────────┘
                                 │
                                 ▼
         ┌──────────────────────────────────────────────┐
S120 ~─ │       FULLY DISCHARGING BATTERY SYSTEM         │
         └───────────────────────┬──────────────────────┘
                                 │
                                 ▼
         ┌──────────────────────────────────────────────┐
S130 ~─ │         MEASURING DISCHARGE CURRENT            │
         └───────────────────────┬──────────────────────┘
                                 │
                                 ▼
         ┌──────────────────────────────────────────────┐
         │   CALCULATING CURRENT MAXIMUM CAPACITY        │
S140 ~─ │   BASED ON RELATIONSHIP BETWEEN               │
         │   DISCHARGE CURRENT AND VOLTAGE               │
         └───────────────────────┬──────────────────────┘
                                 │
                                 ▼
         ┌──────────────────────────────────────────────┐
         │  CALCULATING REMAINING LIFESPAN BASED         │
S150 ~─ │   ON CURRENT MAXIMUM CAPACITY AND             │
         │     MINIMUM MAXIMUM CAPACITY                  │
         └───────────────────────┬──────────────────────┘
                                 │
                                 ▼
                        ╭─────────────╮
                        │     END     │
                        ╰─────────────╯
```

【FIG. 6】

```
                    ┌─────────────┐
                    │    START    │
                    └──────┬──────┘
                           │
                           ▼
        ┌──────────────────────────────────────────┐
S210    │    PARTIALLY CHARGING BATTERY SYSTEM       │
        └──────────────────────┬───────────────────┘
                               │
                               ▼
        ┌──────────────────────────────────────────┐
S220    │    STOPPING CHARGING BATTERY SYSTEM        │
        └──────────────────────┬───────────────────┘
                               │
                               ▼
        ┌──────────────────────────────────────────┐
S230    │    RESUMING CHARGING BATTERY SYSTEM        │
        └──────────────────────┬───────────────────┘
                               │
                               ▼
        ┌──────────────────────────────────────────┐
S240    │         OBTAINING BATTERY SYSTEM           │
        │       INCREMENTAL CAPACITY CURVE           │
        └──────────────────────┬───────────────────┘
                               │
                               ▼
        ┌──────────────────────────────────────────┐
        │  CALCULATING CURRENT MAXIMUM CAPACITY      │
S250    │   OF BATTERY SYSTEM FROM INCREMENTAL       │
        │            CAPACITY CURVE                  │
        └──────────────────────┬───────────────────┘
                               │
                               ▼
        ┌──────────────────────────────────────────┐
        │  CALCULATING REMAINING LIFESPAN BASED      │
S260    │   ON CURRENT MAXIMUM CAPACITY AND          │
        │         INITIAL MAXIMUM CAPACITY           │
        └──────────────────────┬───────────────────┘
                               │
                               ▼
                    ┌─────────────┐
                    │     END     │
                    └─────────────┘
```

【FIG. 7】

【FIG. 8】

【FIG. 9】

```
                    ┌──────────────┐
                    │    START     │
                    └──────┬───────┘
                           │
                           ▼
S310 ─── ┌─────────────────────────────────────────┐
         │    PARTIALLY CHARGING BATTERY SYSTEM     │
         └─────────────────────┬───────────────────┘
                               │
                               ▼
S320 ─── ┌─────────────────────────────────────────┐
         │    STOPPING CHARGING BATTERY SYSTEM      │
         └─────────────────────┬───────────────────┘
                               │
                               ▼
S330 ─── ┌─────────────────────────────────────────┐
         │    RECEIVING BATTERY SYSTEM INTERNAL     │
         │       RESISTANCE MEASUREMENTS            │
         └─────────────────────┬───────────────────┘
                               │
                               ▼
S340 ─── ┌─────────────────────────────────────────┐
         │    CALCULATING CURRENT MAXIMUM           │
         │    CAPACITY BASED ON INTERNAL            │
         │    RESISTANCE MEASUREMENTS               │
         └─────────────────────┬───────────────────┘
                               │
                               ▼
S350 ─── ┌─────────────────────────────────────────┐
         │              MEASURING SOH               │
         └─────────────────────┬───────────────────┘
                               │
                               ▼
                    ┌──────────────┐
                    │     END      │
                    └──────────────┘
```

【FIG. 10】

START

S410 — CHARGING (DISCHARGING) BATTERY SYSTEM TO FIRST CHARGE LEVEL

S420 — STOPPING CHARGING (DISCHARGING) BATTERY SYSTEM

S430 — CHARGING (DISCHARGING) BATTERY SYSTEM TO SECOND CHARGE LEVEL

S440 — CALCULATING PARTIAL CAPACITY BASED ON VOLTAGE-CURRENT RELATIONSHIP

S450 — CALCULATING MAXIMUM CAPACITY USING PARTIAL CAPACITY

S360 — MEASURING SOH

END

【FIG. 11】

【FIG. 12】

poen'

Vehicle Simulator for BSA Control

Main

Diagnostics Info
Cell Info
Setting
About

Disconnected
Diagnose
ON    OFF
Relay OFF

| Diagnostics Info | | Voltage | | | | | | | | Temperature | |
|---|---|---|---|---|---|---|---|---|---|---|---|
| Diag_sig1 | Diag_sig2 | 1 | 0.000 V | 26 | 0.000 V | 51 | 0.000 V | 76 | 0.000 V | 1 | 0 ℃ |
| | | 2 | 0.000 V | 27 | 0.000 V | 52 | 0.000 V | 77 | 0.000 V | 2 | 0 ℃ |
| | | 3 | 0.000 V | 28 | 0.000 V | 53 | 0.000 V | 78 | 0.000 V | 3 | 0 ℃ |
| | | 4 | 0.000 V | 29 | 0.000 V | 54 | 0.000 V | 79 | 0.000 V | 4 | 0 ℃ |
| Diag_sig3 | Diag_sig4 | 5 | 0.000 V | 30 | 0.000 V | 55 | 0.000 V | 80 | 0.000 V | 5 | 0 ℃ |
| | | 6 | 0.000 V | 31 | 0.000 V | 56 | 0.000 V | 81 | 0.000 V | | |
| | | 7 | 0.000 V | 32 | 0.000 V | 57 | 0.000 V | 82 | 0.000 V | | |
| | | 8 | 0.000 V | 33 | 0.000 V | 58 | 0.000 V | 83 | 0.000 V | | |
| Diag_sig5 | Diag_sig6 | 9 | 0.000 V | 34 | 0.000 V | 59 | 0.000 V | 84 | 0.000 V | | |
| | | 10 | 0.000 V | 35 | 0.000 V | 60 | 0.000 V | 85 | 0.000 V | | |
| | | 11 | 0.000 V | 36 | 0.000 V | 61 | 0.000 V | 86 | 0.000 V | | |
| | | 12 | 0.000 V | 37 | 0.000 V | 62 | 0.000 V | 87 | 0.000 V | | |
| Diag_sig7 | Diag_sig8 | 13 | 0.000 V | 38 | 0.000 V | 63 | 0.000 V | 88 | 0.000 V | | |
| | | 14 | 0.000 V | 39 | 0.000 V | 64 | 0.000 V | 89 | 0.000 V | | |
| | | 15 | 0.000 V | 40 | 0.000 V | 65 | 0.000 V | 90 | 0.000 V | | |
| | | 16 | 0.000 V | 41 | 0.000 V | 66 | 0.000 V | 91 | 0.000 V | | |
| Diag_sig9 | Diag_sig10 | 17 | 0.000 V | 42 | 0.000 V | 67 | 0.000 V | 92 | 0.000 V | | |
| | | 18 | 0.000 V | 43 | 0.000 V | 68 | 0.000 V | 93 | 0.000 V | | |
| | | 19 | 0.000 V | 44 | 0.000 V | 69 | 0.000 V | 94 | 0.000 V | | |
| | | 20 | 0.000 V | 45 | 0.000 V | 70 | 0.000 V | 95 | 0.000 V | | |
| Diag_sig11 | Diag_sig12 | 21 | 0.000 V | 46 | 0.000 V | 71 | 0.000 V | 96 | 0.000 V | | |
| | | 22 | 0.000 V | 47 | 0.000 V | 72 | 0.000 V | 97 | 0.000 V | | |
| | | 23 | 0.000 V | 48 | 0.000 V | 73 | 0.000 V | 98 | 0.000 V | | |
| | | 24 | 0.000 V | 49 | 0.000 V | 74 | 0.000 V | | | | |
| | | 25 | 0.000 V | 50 | 0.000 V | 75 | 0.000 V | | | | |

【FIG. 13】

## INTERNATIONAL SEARCH REPORT

| International application No. |
|---|
| **PCT/KR2023/014111** |

**A. CLASSIFICATION OF SUBJECT MATTER**

**B60L 58/16**(2019.01)i; **B60L 58/12**(2019.01)i; **B60L 3/00**(2006.01)i; **G01R 31/392**(2019.01)i; **G01R 31/3842**(2019.01)i; **G01R 31/396**(2019.01)i

According to International Patent Classification (IPC) or to both national classification and IPC

**B. FIELDS SEARCHED**

Minimum documentation searched (classification system followed by classification symbols)

B60L 58/16(2019.01); B60L 3/00(2006.01); B60L 53/30(2019.01); B60L 58/12(2019.01); G01R 31/36(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 재제조(remanufacture), 평가(valuation), 충방전(charge and discharge), 잔존 수명(remaining life), 정규 방식(regular method), 간이 방식(temporary method)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2289155 B1 (BATTERY R&D ASSOCIATION OF KOREA) 11 August 2021 (2021-08-11)<br>See paragraph [0016]; and claim 9. | 1-5 |
| Y | WO 2015-031437 A1 (THE REGENTS OF THE UNIVERSITY OF MICHIGAN) 05 March 2015 (2015-03-05)<br>See paragraph [0007]. | 1-5 |
| Y | 이평연 등. 증분용량곡선 기반 운용 환경별 최적 인자 추출 및 고출력 리튬이온 배터리의 SOH 추정 방법 연구. 전력전자학술대회 논문집. pp. 40-42, 06 July 2021 (LEE, Pyung-Yeon et al. SOH Estimation and Optimal Feature Extraction under Environmental Conditions Using Incremental Capacity Curve for High-Power Lithium-Ion Battery. Proceedings of Power Electronics Annual Conference).<br>[Retrieved on 30 November 2023]. <Retrieved from https://www.dbpia.co.kr/journal/articleDetail?nodeId=NODE10579899>.<br>See page 42; and figure 4. | 2-5 |
| A | KR 10-2020-0122628 A (HYUNDAI MOBIS CO., LTD.) 28 October 2020 (2020-10-28)<br>See paragraphs [0036]-[0066]; and figure 1. | 1-5 |

☑ Further documents are listed in the continuation of Box C.　　☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **21 December 2023** | **22 December 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
|---|
| **PCT/KR2023/014111** |

**C.    DOCUMENTS CONSIDERED TO BE RELEVANT**

| Category* | Citation of document, with indication, where appropriate, of the relevant passages | Relevant to claim No. |
|---|---|---|
| A | KR 10-2021-0134137 A (PMGROW CORPORATION) 09 November 2021 (2021-11-09)<br>　　See paragraphs [0027]-[0031]; and figure 1. | 1-5 |
| PX | KR 10-2560121 B1 (POEN CO., LTD.) 27 July 2023 (2023-07-27)<br>　　See paragraphs [0017]-[0085]; claims 1 and 3; and figures 1-7.<br>　　※ This document is a published earlier application that serves as a basis for claiming<br>　　priority of the present international application. | 1-5 |

Form PCT/ISA/210 (second sheet) (July 2022)

INTERNATIONAL SEARCH REPORT
Information on patent family members

International application No.

**PCT/KR2023/014111**

| Patent document cited in search report | | | Publication date (day/month/year) | Patent family member(s) | | | Publication date (day/month/year) |
|---|---|---|---|---|---|---|---|
| KR | 10-2289155 | B1 | 11 August 2021 | WO | 2022-173174 | A1 | 18 August 2022 |
| WO | 2015-031437 | A1 | 05 March 2015 | US | 10393813 | B2 | 27 August 2019 |
| | | | | US | 2015-0066406 | A1 | 05 March 2015 |
| KR | 10-2020-0122628 | A | 28 October 2020 | CN | 111845353 | A | 30 October 2020 |
| | | | | DE | 102020110365 | A1 | 22 October 2020 |
| | | | | US | 11527900 | B2 | 13 December 2022 |
| | | | | US | 2020-0335979 | A1 | 22 October 2020 |
| KR | 10-2021-0134137 | A | 09 November 2021 | KR | 10-2422594 | B1 | 21 July 2022 |
| KR | 10-2560121 | B1 | 27 July 2023 | | None | | |

Form PCT/ISA/210 (patent family annex) (July 2022)